# EUROPÄISCHE PATENTSCHRIFT

(11) **EP 2 954 554 B1**
(45) Veröffentlichungstag und Bekanntmachung des Hinweises auf die Patenterteilung: **12.04.2017**
(21) Anmeldenummer: 14710196.8
(22) Anmeldetag: 05.02.2014
(51) Int. Cl.: H01L 23/498, H01L 21/48

(54) **MEHREBENENMETALLISIERUNG AUF EINEM KERAMIKSUBSTRAT**
MULTI-LEVEL METALLIZATION ON A CERAMIC SUBSTRATE
MÉTALLISATION MULTINIVEAUX SUR UN SUBSTRAT EN CÉRAMIQUE

(30) Priorität: 07.02.2013 DE 102013202008
(43) Veröffentlichungstag der Anmeldung: 16.12.2015
(73) Patentinhaber: CeramTec GmbH, 73207 Plochingen (DE)
(72) Erfinder: ADLER, Sigurd, 71563 Affalterbach (DE); DILSCH, Roland, 95199 Thierstein (DE); THIMM, Alfred, 95632 Wunsiedel (DE)
(74) Vertreter: Uppena, Franz
(86) Internationale Anmeldenummer: PCT/EP2014/052177
(87) Internationale Veröffentlichungsnummer: WO 2014/122137

(56) Entgegenhaltungen:
- EP-A1- 0 985 999
- EP-A2- 0 529 298
- US-A1- 2008 164 588
- US-A1- 2010 015 468

## Beschreibung

Die Erfindung betrifft ein Verfahren zur Herstellung einer Mehrebenenmetallisierung aus Kupfer auf einem Keramiksubstrat aus AIN oder Al₂O₃, wobei auf ein und demselben Keramiksubstrat Hochleistungsbereiche mit Metallisierungen mit größerer Stromtragfähigkeit und Schwachleistungsbereiche mit Metallisierungen mit geringerer Stromtragfähigkeit geschaffen werden.

Dokument US 2008/164588 offenbart eine Metallisierung aus Kupfer auf einem Keramiksubstrat aus AIN oder Al2 O3, wobei auf ein und demselben Keramiksubstrat Hochleistungsbereiche mit Metallisierungen mit größerer Stromtragfähigkeit und Schwachleistungsbereiche mit Metallisierungen mit geringerer Stromtragfähigkeit geschaffen wurden.

Für leistungselektronische Anwendungen werden metallisierte Keramiksubstrate, auch als Platinen bezeichnet, mit einer dicken Kupferschicht (typisch 200 bis 300 µm) benötigt, um die erforderliche Stromtragfähigkeit zu gewährleisten. Auf diese werden die Leistungshalbleiter gelötet. Auf diesen dicken Kupfer-Strukturen lassen sich nur vergleichsweise grobe Leiterbahnbreiten und Abstände realisieren.

Zur Ansteuerung der Leistungshalbleiter wird eine elektronische Schaltung benötigt. Die dabei verwendeten Bauelemente (Microcontroller, Buskoppler, etc.) und deren metallisierte Trägersubstrate weisen feinere und dünnere elektrische Leiterbahnen und Pitchabstände als die Trägersubstrate für Leistungsbauteile auf. Deshalb werden sie auf einem separaten metallisierten Trägersubstrat montiert. Beide Trägersubstrate werden über Drähte elektrisch miteinander verbunden. Diese Verbindungen altern und neigen zum Ausfall, was zum Ausfall des kompletten Leistungsmoduls führt.

Mit Metallisierungen werden allgemein elektrische Leiterbahnen und flächige Metallisierungen auf Keramiksubstraten bezeichnet, wobei die Leiterbahnen zur Stromleitung und die flächigen Metallisierungen z.B. zum Auflöten von Leistungshalbleitern und Anschlusselementen dienen. Mit Mehrebenenmetallisierung auf einem Keramiksubstrat werden Metallisierungen mit unterschiedlicher Dicke verstanden. Mit Dicke der Metallisierung ist die Ausdehnung dieser senkrecht zur Oberfläche des Keramiksubstrats gemeint. Diese Dicke ist auch mit den Begriffen Höhe oder Stärke zu beschreiben.

Ein weiteres bisher kaum angewendetes Verfahren besteht darin, dass auf der dünnen Kupferschicht einer Leiterbahn eine photochemisch oder über Siebdrucktechnik strukturierte elektrische Isolierschicht aufgebracht wird und auf die frei gelassenen Bereiche wiederum Kupfer elektrochemisch aufgebracht wird. Bei Herstellung eines solchen Mehrstufensubstrats ist bisher ein aufwändiges galvanisches Processing und eine mehrfache Strukturierung mit Galvanoresisten und lichtoptischer Entwicklung und finalem Strippen des Resists notwendig.

Der Erfindung liegt die Aufgabe zugrunde, ein Verfahren nach dem Oberbegriff des Anspruchs 1 so zu verbessern, dass mit einfachen Mitteln Metallisierungen für Hochleistungsbereiche und Metallisierungen für Schwachleistungsereiche gemeinsam und teilweise elektrisch miteinander verbunden auf ein und demselben Keramiksubstrat (keramischen Platte) aufgedruckt werden können, wobei die Hochleistungsbereiche mit dicken Leiterbahnstrukturen eine besonders gute Wärmeleitfähigkeit und Möglichkeit zur guten Wärmespreizung aufweisen sollen.

Erfindungsgemäß wird diese Aufgabe durch die Merkmale des Anspruchs 1 gelöst.

Dadurch, dass die folgenden Verfahrensschritte
a) Aufdrucken einer gemeinsamen Grundmetallisierung für den Hochleistungsbereich und den Schwachleistungsbereiche aus einer glashaltigen Kupferbasispaste mit Siebdruck oder Tampondruck mit einer Dicke von 20 bis 50 µm,
b) Verstärken der Grundmetallisierung in den Hochleistungsbereichen durch mehrfaches oder vielfaches Aufdrucken einer Kupferverstärkungspaste ohne Glasanteil auf die Grundmetallisierung durch Siebdruck oder Schablonendruck bis zu einer Kupfergesamtdicke von 300 bis 500 µm,
c) Einbrennen des metallisierten Keramiksubstrats mit den Hochleistungsbereichen und den Schwachleistungsbereichen gemeinsam bei 850 bis 950 °C in Stickstoff,
d) Mechanisches Einebnen der Hochleistungsbereiche zur Schaffung einer ebenen Oberfläche mit einer Rauheit R_{z} < 5 µm.
nacheinander ausgeführt werden, lassen sich mit einfachen Mitteln Metallisierungen für Hochleistungsbereiche und Metallisierungen für Schwachleistungsereiche gemeinsam und teilweise elektrisch miteinander verbunden auf ein und demselben Keramiksubstrat (keramischen Platte) aufdrucken, wobei die Hochleistungsbereiche mit dicken Leiterbahnstrukturen eine besonders gute Wärmeleitfähigkeit und Möglichkeit zur guten Wärmespreizung aufweisen.

Zum leichteren Auflöten können nach dem Einebnen die Hochleistungsbereiche und/oder die Schwachleistungsbereiche stromlos mit einer Metallisierung wie Ni, NiP+Pd+Au, Ag oder Ni+Au versehen werden.

Zur Vorbereitung für ein späteres Vereinzeln des Keramiksubstrats in einzelne Teilsubstrate kann das Keramiksubstrat durch Laserritzen vor oder nach dem Bedrucken bearbeitet werden.

Damit die Metallisierung der Hochleistungsbereiche eine ebene Oberfläche mit einer Rauigkeit R_{z} < 5 µm aufweisen und damit die Berührungsfläche der Bauelemente mit der Metallisierung möglichst groß ist, werden beim Einebnen bevorzugt 100 bis 150 µm abgetragen. Das Einebnen geschieht bevorzugt durch Schleifen.

Zur Verbesserung der Haftfähigkeit der glasartigen Kupferbasispaste auf dem Keramiksubstrat beträgt der Glasanteil der glashaltigen Kupferbasispaste bevorzugt zwischen 4 und 8 %, besonderst bevorzugt 6 %.

Damit beim Auflöten die Berührungsfläche der Bauelemente mit der Metallisierung möglichst groß ist, weist bevorzugt nach dem Einebnen die Metallisierung des Hochleistungsbereichs eine Dicke von 180 bis 220 µm auf.

Ein erfindungsgemäßes Keramiksubstrat aus AIN oder Al₂O₃ mit einer Mehrebenenmetallisierung aus Kupfer mit Hochleistungsbereichen, mit einer Metallisierung mit größerer Stromtragfähigkeit und Schwachleistungsbereichen, mit einer Metallisierung mit geringerer Stromtragfähigkeit, hergestellt mit dem Verfahren nach einem der Ansprüche 1 bis 6, zeichnet sich dadurch aus, dass die Dicke der Metallisierung im Hochleistungsbereich 180 bis 220 µm und im Schwachleistungsbereich 20 bis 50 µm beträgt und die Haftfestigkeit der Metallisierungen bei über 60 N/qmm liegt.

Die Flankensteilheit der Metallisierung der Hochleistungsbereiche liegt bei einer Gesamtdicke von 200 µm Kupfer bei 120 µm.

Das erfindungsgemäße Verfahren beschreibt eine mehrfach aufgebrachte Kupferpastenmetallisierung. Mit der beschriebenen technischen Lehre können die Hochleistungsbereiche zusammen mit den Schwachleistungsbereichen auf einem gemeinsamen keramischen Träger bzw. Keramiksubstrat aus AIN oder Al₂O₃, nebeneinander aufgebaut werden.

Dazu wird zuerst eine gemeinsame Grundmetallisierung (Hochleistungsbereiche und Schwachleistungsbereiche) aus einer glashaltigen Kupferbasispaste mit Siebdruck oder ähnlichen Techniken wie Tampondruck auf einem Keramiksubstrat aufgebaut. Der Glasanteil der Kupferbasispaste ist wegen der Haftfähigkeit auf der Keramik erforderlich. Die Dicke dieser Grundmetallisierung liegt erfindungsgemäß bei 20-50 µm.

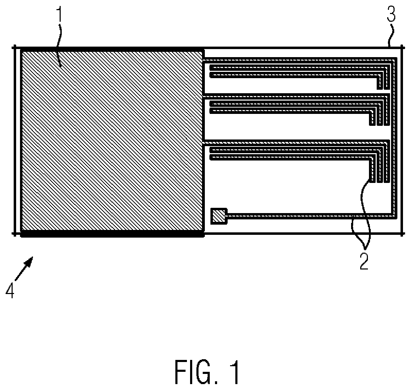

Anschließend werden die Hochleistungsbereiche 1 der Schaltung (siehe das Quadrat links auf Figur 1) auch mehrfach oder vielfach mit Siebdruck oder Schablonendruck selektiv weiter mit einer Kupferverstärkungspaste ausgebaut bzw. verstärkt, vorzugsweise bis zu einer Gesamtdicke von 300 - 500 µm. Diese Kupferverstärkungspaste hat keinen Glasanteil, da sie auf die glashaltige Kupferbasispaste aufgebracht bzw. aufgedruckt wird. Eine Lotverstärkung der glashaltigen Kupferbasispaste wäre nicht geeignet, da Lot eine schlechtere Wärmeleitung als Kupfer hat. Die Hochleistungsbereiche der Schaltung werden, wenn erforderlich, mehrfach mit der Kupferverstärkungspaste überdruckt, so lange, bis die erforderliche Dicke erreicht ist.

Dann wird das metallisierte Keramiksubstrat mit den Hochleistungsbereichen und den Schwachleistungsbereichen gemeinsam bei 850 bis 950°C in N₂ eingebrannt. Das Keramiksubstrat bzw. die Hochleistungsbereiche werden anschließend mechanisch eingeebnet und können bei Bedarf auch mit stromloser Metallisierung wie Ni, NiP+Pd+Au, Ag oder Ni+Au versehen werden. Durch Laserritzen vor oder nach dem Bedrucken der Keramiksubstrate kann man Mehrfachnutzen trennen. Das Einebnen der Hochleistungsbereiche mit dicker Leiterbahnstruktur, beispielsweise durch einen Schleifvorgang, ist erforderlich, um eine ebene Oberfläche mit einer Rauigkeit Rz < 5 µm für die Bauelemente zu schaffen, die üblicherweise mit einer möglichst dünnen Lotschicht befestigt werden. Die Berührungsfläche der Bauelemente mit der Metallisierung ist dadurch maximiert. Es hat sich herausgestellt, dass eine eingeebnete dünnere Metallisierung eine bessere Wärmeableitung hat als eine nicht eingeebnete dickere Metallisierung. Beim Einebnen können durchaus 100 µm bis 150 µm abgetragen werden, ohne Verschlechterung der Wärmeableitung.

Das metallisierte Keramiksubstrat mit den Hochleistungsbereichen und den Schwachleistungsbereichen wird auch als Mehrebenensubstrat bezeichnet. Die Unterseite eines solchen Mehrebenensubstrats kann natürlich ebenfalls strukturiert metallisiert sein, um das Substrat unterseitig durch Löten oder Kleben an einen Kühler anzubinden.

### Beispiel :

Zunächst wird auf einem gelaserten Keramiksubstrat aus AIN mit einer Dicke von 0,63 mm als Metallisierung das gesamte elektrische Layout, bestehend aus einem Hochleistungsbereich und einem Schwachleistungsbereich, mit einer Kupferbasispaste mit einem Glasanteil von 6 % 50 µm hoch bedruckt. Durch Lasern des Keramiksubstrats wird sichergestellt, dass später eine Vereinzelung durch Abbrechen entlang der eingelaserten Sollbruchlinie möglich ist. Dann wird nur noch der Hochleistungsbereich bzw. dessen Metallisierung, auf dem später das Leistungsbauteil gelötet wird, durch weitere auch vielfache Sieb- oder Schablonendruckvorgänge mit einer Kupferverstärkungspaste ohne Glasanteil auf 350 µm Metallisierungsdicke gebracht. Danach wird das metallisierte Bauteil bei 910°C für 8 min in N₂ eingebrannt.

Der Hochleistungsbereich des metallisierten und gebrannten Keramiksubstrats allein ist dann in diesem Beispiel 310 µm hoch metallisiert. Die Metallisierung des Schwachleistungsbereichs ist 40 µm hoch. Der Hochleistungsbereich bzw. sein Kupfer wird dann mechanisch durch einen Schleifvorgang eingeebnet, um eine präzise horizontale Fläche im Hochleistungsbereich zu erzeugen. Das Kupfer hat dann im Hochleistungsbereich nach der Einebnung eine Gesamtdicke von 200 µm.

Die Haftfestigkeit liegt bei über 60 N/qmm. Die Flankensteilheit der Hochleistungsbereiche liegt bei einer Gesamtdicke von 200 µm Kupfer bei 120 µm.

Durch abgestimmte Druckvorgänge mit verschieden starken Schablonen oder Drucksieben kann die Schichtdicke des Hochleistungsbereich gezielt verstärkt werden, bzw. es können durch Reduzierung der Druckvorgänge oder der Schablonenhöhe Schichtdicken dazwischen realisiert werden, falls nur eine geringere Stromtragfähigkeit erforderlich ist.

Figur 1 zeigt einen Ausschnitt aus einem Keramiksubstrat 4 aus Aluminiumnitrid oder Aluminiumoxid mit einer aufgebrachten Metallisierung, die einen Hochleistungsbereich 1 und einen Schwachleistungsbereich 2 umfasst. Die gezeigte Metallisierung ist auf dem Keramiksubstrat im Hochleistungsbereich 1 mehrfach identisch aufgebracht und kann durch Abbrechen entlang einer Sollbruchstelle 3 vereinzelt werden.

Auf dem Keramiksubstrat befinden sich Hochleistungsbereiche 1 und Schwachleistungsbereiche 2 nebeneinander. Mit Hochleistungsbereich 1 ist ein Bereich gemeint, der aufgrund seiner Verwendung eine hohe Stromtragfähigkeit und eine hohe Wärmeableitung hat. Auf Hochleistungsbereiche 1 werden Bauelemente, wie zum Beispiel LED oder Steuertransistoren befestigt, die im Betrieb sehr heiß werden und/oder hohe Schaltleistungen haben. Die hohe elektrische Leistung und die abgegebene Wärme dieser Bauelemente muss geführt bzw abgeführt werden.

Mit Schwachleistungsbereiche 2 sind die Metallisierungen bzw. Leiterbahnen bezeichnet, die eine geringe Wärmeabgabe haben können. Dies sind zum Beispiel die eigentlichen Leiterbahnen einer Schaltung, oft als Logikschaltung bezeichnet.

Ein wesentliches Merkmal der Erfindung ist, dass die Hochleistungsbereiche 1 durch einen Schleifvorgang eingeebnet werden, um eine präzise ondulationsfreie horizontale Fläche mit kleinem Rz (vorzugsweise um 5 µm) zu erzeugen. Nur hierdurch wird die Wärme eines Leistungsbauteils auch durch eine dünne Lotschicht (vorzugsweise um 10 µm) ausreichend abgeführt.

## Patentansprüche

1. Verfahren zur Herstellung einer Mehrebenenmetallisierung aus Kupfer auf einem Keramiksubstrat (4) aus AIN oder Al₂O₃, wobei auf ein und demselben Keramiksubstrat (4) Hochleistungsbereiche (1) mit Metallisierungen mit größerer Stromtragfähigkeit und Schwachleistungsbereiche (2) mit Metallisierungen mit geringerer Stromtragfähigkeit geschaffen werden, **gekennzeichnet durch** folgende Verfahrensschritte, die der Reihe nach auszuführen sind:
e) Aufdrucken einer gemeinsamen Grundmetallisierung für den Hochleistungsbereich (1) und den Schwachleistungsbereiche (2) aus einer glashaltigen Kupferbasispaste mit Siebdruck oder Tampondruck mit einer Dicke von 20 bis 50 µm,
f) Verstärken der Grundmetallisierung in den Hochleistungsbereichen (1) durch mehrfaches oder vielfaches Aufdrucken einer Kupferverstärkungspaste ohne Glasanteil auf die Grundmetallisierung durch Siebdruck oder Schablonendruck bis zu einer Kupfergesamtdicke von 300 bis 500 µm,
g) Einbrennen des metallisierten Keramiksubstrats (4) mit den Hochleistungsbereichen (1) und den Schwachleistungsbereichen (2) gemeinsam bei 850 bis 950 °C in Stickstoff,
h) Mechanisches Einebnen der Hochleistungsbereiche (1) zur Schaffung einer ebenen Oberfläche mit einer Rauheit R_{z} < 5 µm.

2. Verfahren nach Anspruch 1, **dadurch gekennzeichnet, dass** nach dem Einebnen die Hochleistungsbereiche (1) und/oder die Schwachleistungsbereiche (2) stromlos mit einer Metallisierung wie Ni, NiP+Pd+Au, Ag oder Ni+Au versehen werden.

3. Verfahren nach Anspruch 1 oder 2, **dadurch gekennzeichnet, dass** das Keramiksubstrat (4) durch Laserritzen (3) vor oder nach dem Bedrucken, zur Vorbereitung für ein späteres Vereinzeln des Keramiksubstrats (4) in einzelne Teilsubstrate, bearbeitet wird.

4. Verfahren nach einem der Ansprüche 1 bis 3, **dadurch gekennzeichnet, dass** beim Einebnen 100 bis 150 µm abgetragen werden.

5. Verfahren nach einem der Ansprüche 1 bis 4, **dadurch gekennzeichnet, dass** der Glasanteil der glashaltigen Kupferbasispaste zwischen 4 und 8 %, bevorzugt 6 % beträgt.

6. Verfahren nach einem der Ansprüche 1 bis 5, **dadurch gekennzeichnet, dass** nach dem Einebnen die Metallisierung des Hochleistungsbereichs (1) eine Dicke von 180 bis 220 µm aufweist.

7. Keramiksubstrat (4) aus AIN oder Al₂O₃ mit einer Mehrebenenmetallisierung aus Kupfer mit Hochleistungsbereichen (1), mit einer Metallisierung mit größerer Stromtragfähigkeit und Schwachleistungsbereichen (2), mit einer Metallisierung mit geringerer Stromtragfähigkeit, hergestellt mit dem Verfahren nach einem der Ansprüche 1 bis 6, **dadurch gekennzeichnet, dass** die Dicke der Metallisierung im Hochleistungsbereich (1) 180 bis 220 µm und im Schwachleistungsbereich (2) 20 bis 50 µm beträgt und die Haftfestigkeit der Metallisierungen bei über 60 N/qmm liegt.

8. Keramiksubstrat nach Anspruch 7, **dadurch gekennzeichnet, dass** die Flankensteilheit der Metallisierung der Hochleistungsbereiche (1) bei einer Gesamtdicke von 200 µm Kupfer bei 120 µm liegt.

## Claims

1. A method for producing a multi-level metallization of copper on a ceramic substrate (4) of AlN or Al₂O₃, wherein high-power areas (1) having metallizations with greater current-carrying capacity and low-power areas (2) having metallizations with less current-carrying capacity are created on one and the same ceramic substrate (4), **characterised by** the following method steps that are to be carried out sequentially:
e) printing a common base metallization for the high-power area (1) and the low-power areas (2) from a glass-containing copper-based paste using screen printing or pad printing to a thickness of 20 to 50 µm,
f) reinforcing the base metallization in the high-power areas (1) by printing, several or many times, a copper-reinforcement paste without any glass component onto the base metallization by means of screen printing or stencil printing up to a total copper thickness of 300 to 500 µm,
g) annealing the metallized ceramic substrate (4) with the high-power areas (1) and the low-power areas (2) together at 850 to 950°C in nitrogen,
h) mechanical levelling of the high-power areas (1) in order to create a planar surface with a roughness R_{z} < 5 µm.

2. A method according to claim 1, **characterised in that** after the levelling the high-power areas (1) and/or the low-power areas (2) are currentlessly provided with a metallization, such as Ni, NiP+Pd+Au, Ag or Ni+Au.

3. A method according to claim 1 or 2, **characterised in that** the ceramic substrate (4) is processed by laser scribing (3) before or after the printing in order to prepare for subsequent separation of the ceramic substrate (4) into individual sub-substrates.

4. A method according to one of claims 1 to 3, **characterised in that** during the levelling 100 to 150 µm are removed.

5. A method according to one of claims 1 to 4, **characterised in that** the glass component of the glass-containing copper-based paste is between 4 and 8%, preferably 6%.

6. A method according to one of claims 1 to 5, **characterised in that** after the levelling the metallization of the high-power area (1) has a thickness of 180 to 220 µm.

7. A ceramic substrate (4) of AlN or Al₂O₃ having a multi-level metallization of copper with high-power areas (1), having a metallization with greater current-carrying capacity, and low-power areas (2), having a metallization with less current-carrying capacity, produced by the method according to one of claims 1 to 6, **characterised in that** the thickness of the metallization amounts in the high-power area (1) to 180 to 220 µm and in the low-power area (2) to 20 to 50 µm, and the adhesive strength of the metallizations is above 60 N/mm².

8. A ceramic substrate according to claim 7, **characterised in that** the edge steepness of the metallization of the high-power areas (1) given a total copper thickness of 200 µm lies at 120 µm.

## Revendications

1. Procédé de réalisation d'une métallisation multi-niveaux en cuivre sur un substrat céramique (4) en nitrure d'aluminium AlN ou en alumine Al₂O₃, dans lequel on définit, sur un seul et même substrat céramique (4), des domaines haute puissance (1) où la charge limite en courant de la métallisation est relativement forte et des domaines basse puissance (2) où la charge limite en courant de la métallisation est relativement faible, **caractérisé par** les étapes de procédé suivantes, à effectuer dans l'ordre indiqué :
a) imprimer une métallisation de fond commune pour les domaines haute puissance (1) et les domaines basse puissance (2), faite d'une pâte de base au cuivre contenant un verre, à l'aide d'un pochoir de sérigraphie ou d'un tampon de lithographie, en une épaisseur de 20 à 50 µm ;
b) épaissir la métallisation de fond dans les domaines haute puissance (1), en appliquant à plusieurs ou de nombreuses reprises une pâte d'épaississement au cuivre, sans verre, sur la métallisation de fond, à l'aide d'un pochoir de sérigraphie ou d'un tampon de lithographie, jusqu'à obtenir une couche de cuivre d'une épaisseur totale de 300 à 500 µm ;
c) calciner le substrat céramique (4) métallisé, avec les domaines haute puissance (1) et les domaines basse puissance (2), à une température de 850 à 950 °C et sous atmosphère d'azote ;
d) et polir mécaniquement les domaines haute puissance (1), jusqu'à obtenir une surface plane présentant un indice de rugosité R_{z} inférieur à 5 µm.

2. Procédé conforme à la revendication 1, **caractérisé en ce que**, après le polissage, on dote les domaines haute puissance (1) et/ou les domaines basse puissance (2), selon un procédé sans courant, d'une métallisation en un matériau tel que Ni, NiP+Pd+Au, Ag ou Ni+Au.

3. Procédé conforme à la revendication 1 ou 2, **caractérisé en ce que** le substrat céramique (4) est doté, avant ou après impression, de rainures (3) pratiquées par gravure au laser, en prévision d'une division ultérieure du substrat céramique (4) en substrats partiels individuels.

4. Procédé conforme à l'une des revendications 1 à 3, **caractérisé en ce que** lors du polissage, on enlève de 100 à 150 µm d'épaisseur.

5. Procédé conforme à l'une des revendications 1 à 4, **caractérisé en ce que** la proportion de verre dans la pâte de base au cuivre contenant un verre vaut entre 4 et 8 %, et de préférence 6 %.

6. Procédé conforme à l'une des revendications 1 à 5, **caractérisé en ce que**, après le polissage, l'épaisseur de la métallisation, dans le domaine haute puissance (1), vaut de 180 à 220 µm.

7. Substrat céramique (4), en nitrure d'aluminium AlN ou en alumine Al₂O₃, doté d'une métallisation multi-niveaux en cuivre comportant des domaines haute puissance (1) où la charge limite en courant est relativement forte et des domaines basse puissance (2) où la charge limite en courant est relativement faible, fabriqué selon un procédé conforme à l'une des revendications 1 à 6, **caractérisé en ce que** l'épaisseur de la métallisation vaut de 180 à 220 µm dans le domaine haute puissance (1) et de 20 à 50 µm dans le domaine basse puissance (2), et **en ce que** la force d'adhérence de la métallisation vaut plus de 60 N/mm².

8. Substrat céramique conforme à la revendication 7, **caractérisé en ce que** la largeur des flancs de la métallisation du domaine haute puissance (1), pour une épaisseur totale de cuivre de 200 µm, vaut 120 µm.
